# EUROPEAN PATENT APPLICATION

(11) **EP 2 703 346 A1**
(43) Date of publication of application: **05.03.2014**
(21) Application number: 12777285.3
(22) Date of filing: 27.04.2012
(51) Int. Cl.: C01B 21/072

(54) **METHOD FOR PRODUCING WATER-RESISTANT ALUMINUM NITRIDE**

(30) Priority: 28.04.2011 JP 2011102139; 28.04.2011 JP 2011102140
(71) Applicant: Tokuyama Corporation, Shunan-shi, Yamaguchi 745-0053 (JP)
(72) Inventor: OHNO, Hideki, Yamaguchi 745-0053 (JP); WANG, Meng, Yamaguchi 745-0053 (JP); TAMAGAKI, Megumu, Yamaguchi 745-0053 (JP)
(74) Representative: Albrecht, Thomas
(86) International application number: PCT/JP2012/061785
(87) International publication number: WO 2012/147999

(57) **Abstract**

The present invention relates to a method of manufacturing water resistant aluminum nitride powder, the method comprises; in a solvent, performing phosphoric acid compound treatment in which at least one phosphoric acid compound selected from the group consisting of phosphoric acid, metal salts of phosphoric acid and organic phosphoric acid having an organic group with 12 or less carbon atoms is contacted with aluminum nitride powder dispersed in the solvent so that the ratio of median diameter/primary particle diameter is 1.4 to 5, thereby the phosphoric acid compound is present on the surface of the aluminum nitride powder at a rate of 0.5 to 10 mg/m² in the orthophosphoric acid ion equivalence.

## Description

### TECHNICAL FIELD

The present invention relates to a method of manufacturing water resistant aluminum nitride powder. Specifically, the present invention relates to a method of manufacturing aluminum nitride powder having good water resistance in which the excellent thermal conductivity of the original aluminum nitride powder is highly maintained.

The water resistant aluminum nitride powder manufactured according to the method of the present invention can confer high thermal conductivity on a thermal conductive composite material when the powder is used to fill the thermal conductive composite material.

### BACKGROUND ART

Recent increase in the power density of semiconductor devices requires heat radiation materials with higher heat radiation characteristics.

Materials which can be used for heat dissipation of semiconductor devices include a series of materials called a thermal interface material. The amount of their use is rapidly expanding. The thermal interface materials are those for decreasing thermal resistance in the pathway through which the heat generated by a semiconductor element is released to a heat sink or a housing. They are used in various forms such as a sheet, a gel and a grease form.

In general, the thermal interface materials are a composite material in which a thermal conductive filler is dispersed in suitable resin such as epoxy resin and silicone resin. As the filler, silica or alumina is often used. However, the thermal conductivity of silica and alumina is only 40 W/mK and 1 W/mK, respectively. For example, in the case of a composite material in which alumina is used, the thermal conductivity will be at most about 1 to 3 W/mK.

Meanwhile, in recent years, the power density of semiconductor devices has increased, and thus a thermal interface material having ever-higher thermal conductivity has been required. In this context, thermal interface materials in which nitride based inorganic substances having high thermal conductivity are used as the fillers are increasing their presence in the market. The thermal conductivity in the nitride based inorganic substances appears to be achieved due to a smooth phonon propagation resulted from the strong bonding between metal ions and anions. For the nitride based inorganic substance, aluminium nitride is typically used.

However, the following problems have been pointed out for aluminium nitride. First, aluminium nitride has low affinity with resin in the composite materials, and thus is not possible to be filled densely the resin; Second, the surface is hydrolyzed and aluminium hydroxide and ammonia are generated upon contacting with water in powder state since it is highly reactive with water. Thermal resistance at the interface with the resin is increased due to low affinity with the resin. As a result, currently a composite material having satisfactorily high thermal conductivity can not be obtained.

In order to solve these problems described above, attempts have been made in which the surface of aluminum nitride powder is modified.

For example, Japanese Patent Laid-Open No. H11-209618 discloses a technology in which the surface of aluminum nitride powder is treated with phosphoric acid. According to this method, the water resistance of the powder is improved to some extent, but the affinity with resin becomes even lower. Therefore, the composite material can not be filled in the resin with a high filler content due to significantly increased viscosity. As a result, the thermal conductivity of the composite material obtained according to this technology still remains insufficient.

Japanese Patent Laid-Open No. H7-33415 discloses a technology in which the surface of aluminum nitride powder which has been subjected to phosphoric acid surface treatment is further treated with a silane coupling agent, a phosphoric acid based coupling agent and the like to improve water resistance. According to this technology, the affinity with resin may be improved by the function of the coupling agents. However, since a considerable amount of the coupling agents is required in order for them to fully function, the surface coating layer of the aluminum nitride powder is thick, and as a result, the thermal conductivity of the surface of the powder may be compromised. Further, increase in cost due to the two step processing will also pose a problem.

Japanese Patent Laid-Open No. 2002-226207 discloses a technology in which an aluminum oxide layer is formed on the surface of aluminum nitride powder, and then phosphoric acid treatment is performed to further improve water resistance. However, this technology has a problem that the thermal conductivity of the surface of aluminum nitride powder is further reduced although high water resistance can be achieved. This is because an aluminum oxide layer is also formed on the surface of the powder in addition to the coating layer by the phosphoric acid treatment.

### SUMMARY OF INVENTION

Accordingly, an object of the present invention is to provide a method of manufacturing water resistant aluminum nitride powder having good water resistance in which the thickness of a treatment agent layer which confers such water resistance is reduced. The water resistant aluminum nitride powder manufactured according to the method of the present invention shall have a treatment agent layer with a reduced thickness, and show excellent thermal conductivity maintained at a high level comparably to that of the original aluminum nitride powder. In a case where a thermal conductive composite material is filled with the water resistant aluminum nitride powder manufactured according to the method of the present invention, high thermal conductivity shall be conferred on the thermal conductive composite material.

After conducting extensive studies to achieve the above object, the present inventors find that a thin phosphoric acid compound layer can be formed on the surface by dispersing aluminum nitride powder or aluminum nitride powder in which an aluminum oxide layer is formed on the surface (hereinafter may be collectively called simply "aluminum nitride powder") in a solvent to achieve a particular dispersion state, and allowing contact with a particular phosphoric acid compound in the liquid. The presence of this layer successfully gives the aluminum nitride powder both excellent water resistance and high thermal conductivity. Then the present inventors complete the present invention.

That is, the present invention includes a method of manufacturing water resistant aluminium nitride powder, the method comprising:
in a solvent,
performing phosphoric acid compound treatment in which at least one phosphoric acid compound selected from the group consisting of phosphoric acid, metal salts of phosphoric acid and organic phosphoric acid having an organic group with 12 or less carbon atoms is contacted with aluminum nitride powder dispersed in the solvent so that the ratio of median diameter/primary particle diameter is 1.4 to 5,
thereby the phosphoric acid compound is present on the surface of the aluminum nitride powder in an amount of 0.5 to 10 mg/m² in the orthophosphoric acid ion equivalence.

### <Aluminum nitride powder>

For the aluminum nitride powder in the present invention, any one manufactured according to conventionally known methods can be used without any particular limitation. Methods of manufacturing the aluminum nitride powder of the present invention can include, for example, the direct nitridation method, the carbothermal nitridation method, the vapor phase synthesis method and the like.

The aluminum nitride powder used for the present invention preferably has an aluminum oxide layer on the surface in order to enhance efficiency of the phosphoric acid compound treatment. This aluminum oxide layer may be an oxide layer formed by natural oxidation during storage of the aluminum nitride powder, or may be an oxide layer formed in an intentional oxidation treatment step. This oxidation treatment step may be carried out during the manufacturing process of the aluminum nitride powder, or after the aluminum nitride powder is manufactured in a separate step. For example, the aluminum nitride powder obtained by the carbothermal nitridation method inherently has an aluminum oxide layer on the surface because it has been subject to an oxidation treatment step in the manufacture process in order to remove carbon used for the reaction. An oxidation treatment step may be further performed on the aluminum nitride powder obtained by the carbothermal nitridation method.

In a case where an oxidation treatment step is performed at a separate step, the conditions are as follows.

An aluminum oxide layer can be formed on the surface of powder by heating aluminum nitride powder under an oxygen-containing atmosphere preferably at temperature of 400 to 1,000°C, more preferably at temperature of 600 to 900°C preferably for 10 to 600 minutes, more preferably for 30 to 300 minutes. For the above oxygen-containing atmosphere, for example, oxygen, air, steam, carbon dioxide and the like can be used, but for the purpose of the present invention, the treatment in air, in particular under the atmospheric pressure is sufficient.

The thickness of the above aluminum oxide layer may be selected in a range where the thermal conductivity of the aluminum nitride powder is not significantly decreased, and may be adjusted to a thickness of preferably 2 to 10 nm, more preferably 3.6 to 8 nm.

In the present invention, the primary particle diameter of the aluminum nitride powder may be appropriately selected depending on its application, and shall not be particularly limited. The primary particle diameter of the aluminum nitride powder in the present invention suitably has a number average particle diameter of about 0.1 to 2 µm. In a case where the aluminum nitride powder has an aluminum oxide layer, the above particle diameter means a particle diameter including the thickness of the aluminum oxide layer.

The BET specific surface area of the aluminum nitride powder of the present invention is preferably about 1 to 5 m²/g.

There is no particular limitation for the shapes of the primary particles of the aluminum nitride powder of the present invention, for example, they can be in any shape such as an crushed shape and a spherical shape.

### <Phosphoric acid compound>

The phosphoric acid compound used in the present invention is at least one selected from the group consisting of phosphoric acid, metal salts of phosphoric acid and organic phosphoric acid having an organic group with 12 or less carbon atoms.

The above phosphoric acid embodies a concept encompassing condensed phosphoric acid such as pyrophosphoric acid (H₄P₂O₇), metaphosphoric acid ((HPO₃)ₙ, wherein n is an integer showing a degree of condensation) in addition to orthophosphoric acid (H₃PO₄).

The above metal salts of phosphoric acid include alkali metal salts, alkaline earth metal salts, an aluminium salt, a gallium salt, a lanthanum salt and the like of the above phosphoric acid. The above alkali metal salts can include, for example, a lithium salt, a potassium salt, a sodium salt and the like. The above alkaline earth metal salts can include, for example, a magnesium salt, a calcium salt, a strontium salt, a barium salt and the like.

Examples of the above organic phosphoric acid having an organic group with 12 or less carbon atoms can include, for example, methylphosphonic acid, ethylphosphonic acid, propylphosphonic acid, butylphosphonic acid, pentylphosphonic acid, hexylphosphonic acid, octylphosphonic acid, vinylphosphonic acid, phenylphosphonic acid, methylphosphoric acid, ethylphosphoric acid, propylphosphoric acid, butylphosphoric acid, pentylphosphoric acid, hexylphosphoric acid, octylphosphoric acid, laurylphosphoric acid, acid phosphoxy ethyl metacrylate and the like. Among these, the organic phosphoric acid in the present invention is preferably organic phosphoric acid having an organic group with 6 or less carbon atoms. More preferred examples include methylphosphonic acid, ethylphosphonic acid, propylphosphonic acid, butylphosphonic acid, pentylphosphonic acid, hexylphosphonic acid, vinylphosphonic acid, phenylphosphonic acid, methylphosphoric acid, ethylphosphoric acid, propylphosphoric acid, pentylphosphoric acid, hexylphosphoric acid, and acid phosphoxy ethyl metacrylate. Phenylphosphonic acid is particularly preferred. Phenylphosphonic acid has the following structure.

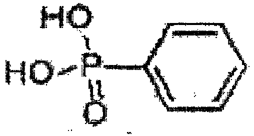

Phenylphosphonic acid has an effect to further increase the affinity of the resulting water resistant aluminum nitride powder with resin. Therefore, the water resistant aluminum nitride powder manufactured using phenylphosphonic acid has an advantage that a composite material having low viscosity and high thermal conductivity can be achieved since the viscosity of the composite material does not increase significantly even if the filler content of the water resistant aluminum nitride powder is increased when manufacturing a thermal conductive composite material.

In the present invention, the above phosphoric acid compounds may be used alone or in combination of two or more.

### <Phosphoric acid compound treatment step>

The method of the present invention comprises a phosphoric acid compound treatment step in which the above phosphoric acid compound is contacted with the above aluminum nitride powder dispersed in a solvent so that the ratio of median diameter/primary particle diameter is 1.4 to 5.

In the phosphoric acid treatment step in the present invention, the above aluminum nitride powder is dispersed in a solvent so that the ratio of median diameter/primary particle diameter is 1.4 to 5 to form a slurry state. The median diameter is a particle diameter corresponding to the median in a particle size distribution curve of the powder, which can be determined by, for example, particles size distribution measurements with a commercially available laser diffraction scattering particle diameter distribution measurement system (for example, Model "MT3300" from Nikkiso Co., Ltd. and the like). The primary particle diameter means a number average value for particles in a minimum unit which constitutes the powder. For example, it can be determined with an image under a scanning electron microscope. Specifically, it can be easily determined by a method comprising: taking an image of the powder at a magnification of 2,000 times or 10,000 times using a commercially available scanning electron microscope (for example, Model "JSM-5300", from JEOL Co., Ltd. and the like); and measuring a size for 100 particles randomly selected in the image to obtain the mean value. The ratio of median diameter/primary particle diameter described above is preferably 1.4 to 4, more preferably 1.4 to 3.

In a case where the ratio of median diameter/primary particle diameter is larger than 4, the treatment agent layer needs to be thick in order to give sufficient water resistance. As a result, the thermal conductivity of the resulting water resistant aluminum nitride powder will be decreased, and therefore, the object of the present invention is difficult to be achieved. On the other hand, in a case where the ratio of median diameter/primary particle diameter is smaller than 1.4, an effect to obtain high water resistance with a thin treatment agent layer shows the plateau, showing a disadvantage in terms of dispersion cost. Further, the water resistant aluminum nitride powder obtained from a dispersion state in which the median diameter/primary particle diameter is too small will pose a problem that viscosity increases when applied to a thermal conductive composite material. Moreover, in a case where the median diameter is too small, strong aggregation may occur in a drying step preferably performed after the phosphoric acid compound treatment step. When the aggregates are crushed, a new surface which does not have the treatment agent layer is exposed, and the water resistance may be compromised.

Examples of the devices suitable for obtaining such a high dispersion state include, for example, dispersers, homogenizers, ultrasonic dispersion devices, wet ball mills, wet vibration ball mills, wet beads mills, Nanomizers, collision dispersing devices such as highpressure dispersion devices and the like.

In the present invention, the aluminum nitride powder in a solvent may be contacted with a phosphoric acid compound after dispersed to form the slurry as described above, or both the aluminium nitride and the phosphoric acid compound may be added together in a solvent, and then dispersed to form the slurry as described above. In either case, the dispersion state is preferably maintained until the preferred contact time described below has elapsed.

In the phosphoric acid compound treatment step in the present invention, by contacting the aluminum nitride powder in the dispersion state described above with a phosphoric acid compound, the phosphoric acid compound is allowed to be present on the surface of the aluminum nitride powder in an amount of 0.5 to 10 mg/m² in the orthophosphoric acid ion equivalence. The amount of the phosphoric acid compound on the surface of the aluminum nitride powder is preferably 0.8 to 6.0 mg/m² in the orthophosphoric acid ion equivalence. Such amount allows a thin and uniform phosphoric acid compound layer on the surface of the aluminum nitride powder, and the water resistance can be improved without sacrificing the thermal conductivity of aluminium nitride.

In a case where two or more phosphoric acid compounds are used in combination, the amount of the phosphoric acid compounds is the total amount of all the phosphoric acid compounds.

In the present invention, for the phosphoric acid compounds, a first phosphoric acid compound comprising at least one selected from the group consisting of phosphoric acid and metal salts of phosphoric acid, and a second phosphoric acid compound comprising at least one selected from organic phosphoric acids having an organic group with 12 or less carbon atoms are preferably used in combination. The total amount of the first phosphoric acid compound and the second phosphoric acid compound is preferably within the above range. Among these, the amount of the second phosphoric acid compound is preferably 0.002 to 1.5 mg/m², more preferably 0.01 to 0.8 mg/m² in the orthophosphoric acid ion equivalence. Such amounts can confer high hydrophobicity on the resulting water resistant aluminum nitride powder, and allows a higher filler content into resin in a heat radiation composite material.

The amount of the phosphoric acid compound can be easily quantified, for example by inductively coupled plasma emission spectrometry (ICP-AES), atomic absorption spectrophotometry and the like.

The solvents used for the phosphoric acid compound treatment step in the present invention are preferably solvents in which the phosphoric acid compounds can be dissolved, including, for example, water, alcohols, esters, ketones, ether and the like. Examples of such solvents can include, for example, methanol, ethanol, 1-propanol, 2-propanol, 1-butanol, 2-butanol, isobutanol and the like as the alcohols;
for example, methyl formate, ethyl formate, propyl formate, butyl formate, methyl acetate, ethyl acetate, propyl acetate, butyl acetate and the like as the esters;
for example, acetone, methyl ethyl ketone and the like as the ketones;
for example, dioxane, diethyl ether, ethylene glycol monomethyl ether, ethylene glycol monoethyl ether, ethylene glycol dimethyl ether, ethylene glycol diethyl ether, diethylene glycol monomethyl ether, diethylene glycol monoethyl ether, diethylene glycol dimethyl ether, diethylene glycol diethyl ether, propylene glycol monomethyl ether, propylene glycol monoethyl ether and the like as the ethers, respectively. These solvents may be used alone or in combination of two or more.

In the phosphoric acid compound treatment step of the present invention, water is preferably used as a solvent given that explosion proof equipment and solvent recovery equipment are not required.

Contacting the aluminum nitride powder with the phosphoric acid compound in a solvent at the phosphoric acid compound treatment step can be performed by, for example, a method in which the aluminum nitride powder is dispersed in a solution containing a desired phosphoric acid compound, a method in which a phosphoric acid compound is dissolved in a solvent where the aluminum nitride powder is dispersed, a method in which a solvent where the aluminum nitride powder is dispersed and a solution containing a phosphoric acid compound are mixed, a method in which the above dispersion state is created from a state where both the aluminum nitride powder and the phosphoric acid compound are present in the same solvent and the like.

For the amount of the solvent used for contacting the aluminum nitride powder with the phosphoric acid compound, the total mass of the aluminum nitride powder and the phosphoric acid compound accounts for a proportion of preferably 10 to 70 mass%, more preferably 20 to 60 mass% relative to the total mass of the reaction system (the total mass of a slurry comprising the aluminum nitride powder, the phosphoric acid compound and the solvent).

Contacting the aluminum nitride powder with the phosphoric acid compound in a solvent is performed at a temperature of preferably 0 to 100°C, more preferably 10 to 80°C for preferably 5 minutes to 50 hours, more preferably 10 minutes to 25 hours.

The slurry of the aluminum nitride powder after completing the phosphoric acid compound treatment step is preferably subjected to a drying step (a step of evaporatively removing a solvent) described below without removing the excess solvent or after removing the excess solvent by appropriate methods such as decantation and filtering.

In a case where the slurry of the aluminum nitride powder after completing the phosphoric acid compound treatment step is subjected to a drying step without removing the excess solvent, the amount of the phosphoric acid to be used in the step can be easily computed from the desired amount of the phosphoric acid compound in the resulting water resistant aluminum nitride particles because all of the phosphoric acid compound used in the phosphoric acid compound treatment step remains on the surface of the powder.

On the other hand, in a case where the excess solvent is removed from the slurry of the aluminum nitride powder after completing the phosphoric acid compound treatment step and then subjected to a drying step, only a portion of the phosphoric acid compound remains on the surface of the powder because a portion of the phosphoric acid compound is expelled outside the system together with the solvent. Even in this case, the amount of the phosphoric acid compound on the resulting water resistant aluminum nitride particles can be determined with inductively coupled plasma emission spectrometry (ICP-AES), atomic absorption spectrophotometry and the like as described above. Therefore, the optimum amount of the phosphoric acid compound to be used at the phosphoric acid compound treatment step in order to allow a desired rate of the phosphoric acid compound to be present on the surface can be determined from a few preliminary experiments by a person skilled in the art.

### - Drying step -

As described above, the aluminum nitride powder contacted with the phosphoric acid compound in a solvent is preferably subjected to a drying step (a step of evaporatively removing a solvent).

In a case where this drying step is performed under ordinary pressure, a method is suitably used in which the aluminium nitride slurry is heated at a temperature in the range between 80 and 300°C. The heating temperature is preferably 100 to 280°C, more preferably 120 to 250°C. The heating temperature for drying under reduced pressure can be suitably selected depending on a degree of reduced pressure.

When the drying temperature in the drying step is too low, the water resistance of the resulting water resistant aluminum nitride powder may be compromised due to insufficient drying. On the other hand, when the drying temperature is too high, aggregation of the aluminum nitride powder may be induced, and the phosphoric acid compound on the surface may be decomposed or evaporated off. Drying duration is preferably 1 to 48 hours, more preferably 6 to 24 hours.

Known methods and devices can be used for this drying step. For example, drying in an oven under atmospheric pressure, drying in an oven under reduced pressure, spray dryers, media slurry dryers, shaking mixers equipped with drying mechanism, ploughshare mixers and the like can be used.

### - Embodiments of the phosphoric acid compound treatment step -

The phosphoric acid compound treatment step as described above (and the optionally following drying step) may be performed in one step, or may be performed in two steps. In a case where the phosphoric acid compound treatment step is performed in one step, the phosphoric acid compounds may be used alone or in combination of two or more. In a case where the phosphoric acid compound treatment step is performed in two steps, the phosphoric acid compounds may be used alone or in combination of two or more in each step, and the phosphoric acid compound used in each process may be the same, or may be different.

A particularly preferred embodiment of the phosphoric acid compound treatment step of the present invention comprises:
contacting a first phosphoric acid compound comprising at least one selected from the group consisting of phosphoric acid and metal salts of phosphoric acid, and
a second phosphoric acid compound comprising at least one selected from organic phosphoric acids having an organic group with 12 or less carbon atoms simultaneously or sequentially in no particular order; and
most preferably, comprises: contacting the first phosphoric acid compound and the second phosphoric acid compound simultaneously, wherein the first phosphoric acid compound is phosphoric acid (H₃PO₄) or aluminium phosphate (AlPO₄), and the second phosphoric acid compound is phenylphosphonic acid.

Therefore, according to the most preferred embodiment of the present invention, obtained will be water resistant aluminum nitride powder having a layer comprising phosphoric acid and phenylphosphonic acid on the surface, wherein the total amount of these is 0.5 to 10 mg/m², preferably 0.8 to 6.0 mg/m² in the orthophosphoric acid ion equivalence, and the amount of phenylphosphonic acid therein is 0.002 to 1.5 mg/m², preferably 0.01 to 0.8 mg/m² in the orthophosphoric acid ion equivalence.

### <Water resistant aluminum nitride powder>

Water resistant aluminum nitride powder is obtained according to the method of the present invention as described above.

The water resistant aluminum nitride powder obtained according to the method of the present invention has a phosphoric acid compound on the surface in an amount of 0.5 to 10 mg/m² in the orthophosphoric acid ion equivalence. The phosphoric acid compound is presumed to be chemically and/or physically attached on the surface of the aluminum nitride powder preferably through an aluminum oxide layer.

The water resistant aluminum nitride powder obtained according to the method of the present invention has good water resistance as well as excellent thermal conductivity maintained at a high level comparable to that of the original aluminum nitride powder. Therefore, the water resistant aluminum nitride powder can be suitably used as a filler for a thermal conductive composite material.

### <Thermal conductive composite material>

The water resistant aluminum nitride powder obtained according to the method of the present invention can be suitably used as a thermal conductive composite material by mixing this with resin.

Examples of the resin which can be used in this context can include any of thermoplastic resin and thermosetting resin. Examples of the thermoplastic resin include, for example, polyethylene, polypropylene, ethylene-propylene copolymer, polymethylpentene, polyvinyl chloride, polyvinylidene chloride, polyvinyl acetate, ethylene-vinylacetate copolymer, polyvinyl alcohol, polyacetal, fluororesin (for example, poly(vinylidene fluoride), polytetrafluoroethylene and the like), polyethylene terephthalate, polybutylene terephthalate, polyethylene-2,6-naphthalate, polystyrene, polyacrylonitrile, styrene-acrylonitrile copolymer, ABS resin, polyphenylene ether (PPE) resin, modified PPE resin, aliphatic polyamide, aromatic polyamide, polyimide, polyamidoimide, polymethacrylic acid, polymethacrylic acid ester (for example, polymethyl methacrylate and the like), polyacrylic acid, polyacrylic acid ester (for example, poly(methyl acrylate) and the like), polycarbonate, polyphenylene sulfide, polysulfone, polyether sulfone, polyethernitrile, polyether ketone, polyether ether ketone, polyketone, liquid crystal polymer, ionomer and the like.

Examples of the thermosetting resin can include, for example, epoxy resin, acrylic resin, urethane resin, silicone resin, phenol resin, imide resin, thermosetting modified PPE, thermosetting PPE and the like.

As described above, the water resistant aluminum nitride powder obtained according to the method of the present invention has excellent affinity with resin. Therefore, when mixed with resin, an increased filler content can be achieved. The water resistant aluminum nitride powder obtained according to the method of the present invention can be mixed in an amount of 60 to 85 parts by mass relative to 100 parts by mass of resin. Further high filler content of 75 to 85 parts by mass is possible.

Applications of the thermal conductive composite material manufactured using the water resistant aluminum nitride powder obtained according to the method of the present invention can include, for example, materials for thermal conductive components to efficiently releasing heat from semiconductor components used in home electronics, cars, laptop personal computers and the like. Specific examples of these can include, for example, thermal conductive grease, thermal conductive gel, thermal conductive sheets, phase changing sheets, adhesives and the like. In addition to these, the above composite materials can be used as insulating layers used for, for example, metal base substrates, printed boards, flexible boards and the like; semiconductor packaging materials; underfill; housing; radiation fin; and the like.

### Examples

In the followings, the present invention will be described in detail with reference to Examples and Application Examples. However, the present invention shall not be construed as limited to these Examples.

Various tests in the following Examples were conducted by the corresponding methods described below.

### <Median diameter/primary particle diameter>

An image of powder was acquired at a magnification of 2,000 times or 10,000 times using a scanning electron microscope (JSM-5300, JEOL Co., Ltd.), and a size was measured for 100 particles randomly selected in the image, and the mean value was taken as the primary particle diameter.

The median diameter was determined by diluting a slurry immediately after mixed and dispersed in each of the following Examples with ion exchanged water, and measuring particle size distribution using a laser diffraction scattering particle size distribution measurement system (MT3300, Nikkiso Co., Ltd.) without performing ultrasonic irradiation.

The ratio of the median diameter to the primary particle diameter was taken as "median diameter/primary particle diameter."

### <Thickness of an aluminum oxide layer on the surface of aluminum nitride powder>

Using a X ray photoelectron spectrometer (ESCA5701 ci/MC, ULVAC-PHI, INC.), the thickness of an Al₂O₃ layer was determined from the ratio of AlN and Al₂O₃ after measuring spectra of N₁ₛ, O₁ₛ and Al₂ₚ on the surface of the powder with an analysis depth of 10 nm.

For example, in the case of AlN 50% and Al₂O₃ 50%, the thickness of the oxide layer will be calculated to be 5 nm (50 % of the analysis depth).

### <Water resistance of aluminum nitride powder>

To a 120 mL Teflon® hermetic vessel (a PFA pressure tight jar, Flon Industry), 2 g of aluminum nitride powder and 100 g of ion exchanged water were added, and left for stand at 120°C. After 6, 12 and 24 hours, the values of pH were measured for the water with pH test strips. In this context, the value of pH of 10 or more indicated the loss of water resistance. The time to the loss of water resistance, which was defined as water resistance time, was classified into 4 categories: less than 6 hours (< 6), 6 hours or more but less than 12 hours (< 12), 12 hours or more but less than 24hours (< 24) and 24 hours or more (≥ 24).

### <Viscosity of composite material>

Viscosity was measured at 25.5°C using a rheometer (AR2000ex, TA Instruments) for a sample obtained by mixing 2.0 g of aluminum nitride powder and 0.91 g of epoxy resins (ZX-1059, Nippon Steel Chemical Co., Ltd.) with a mortar.

### <Thermal conductivity of composite material>

A coated film having a thickness of about 200 to 300 µm was formed by mixing 8.0 g of aluminum nitride powder, 2.2 g of epoxy resin (JER807, Mitsubishi Chemical Corporation) and an appropriate amount of 2-methoxyethanol (Wako Pure Chem Industries, Ltd.) with a mortar, and then applying the mixture to a PET film using a bar coater (PI-1210, Tester Sangyo Co., Ltd.), and heating at 80°C for 1 hour, and then further heating at 150°C for 3 hours to perform dry curing.

At this step, the amount of 2-methoxyethanol to be used was varied for each sample to adjust the viscosity of the sample so that the thickness of the coated film after dry curing fell into the above range.

Thermal conductivity was measured for the film obtained above using a Quick Thermal Conductivity Meter (QTM-500, Kyoto Electronics Manufacturing Co., Ltd.). Quartz glass, silicone rubber and zirconia were used for the reference.

### Example 1

With a mortar, 1 kg of aluminum nitride powder (Grade H, the BET specific surface area: 2.6 m²/g, Tokuyama Corporation), 9.4 g of phosphoric acid (H₃PO₄, Special grade, H₃PO₄ content 85 wt%, Wako Pure Chem Industries, Ltd.) and 1.5 kg of water were mixed, and then dispersed and mixed at a pressure of 100 MPa using a Nanomizer (NMS-200L, Nanomizer Inc.). Subsequently, the dispersion mixture was dried with a spray dryer (R-100, Preci Co.,Ltd.) at an inlet temperature of 200°C, and then further dried in a 120°C oven for 15 hours to obtain water resistant aluminum nitride powder.

The water resistance of the resulting aluminum nitride powder, and the viscosity and thermal. conductivity of a composite material manufactured with this aluminum nitride powder are shown in Table 1.

### Example 2

Using an attritor (MA-01C, Mitsui Miike Machinery Co., Ltd.), 1 kg of aluminum nitride powder (Grade H, the BET specific surface area: 2.6 m²/g, Tokuyama Corporation), 7.1 g of phosphoric acid (Special grade, H₃PO₄ content 85 wt%, Wako Pure Chem Industries, Ltd.) and 1.5 kg of ethanol were dispersed and mixed, and then dried at 100°C for 15 hours to obtain water resistant aluminum nitride powder.

The water resistance of the resulting aluminum nitride powder, and the viscosity and thermal conductivity of a composite material manufactured with this aluminum nitride powder are shown in Table 1.

### Example 3

Using a vibration ball mill (New Light, Chuo Kakohki Co., Ltd.), 1 kg of aluminum nitride powder (Grade H, the BET specific surface area: 2.6 m²/g, Tokuyama Corporation), 4.7 g of phosphoric acid (Special grade, H₃PO₄ content 85 wt%, Wako Pure Chem Industries, Ltd.), 0.1 g of phenylphosphonic acid (Wako Pure Chem Industries, Ltd.) and 1.5 kg of isopropanol were dispersed and mixed, and then dried at 200°C for 15 hours to obtain water resistant aluminum nitride powder.

The water resistance of the resulting aluminum nitride powder, and the viscosity and thermal conductivity of a composite material manufactured with this aluminum nitride powder are shown in Table 1.

### Example 4

1 kg of aluminum nitride powder (Grade F, the BET specific surface area: 3.4 m²/g, Tokuyama Corporation), 5.0 g of phosphoric acid (Special grade, H₃PO₄ content 85 wt%, Wako Pure Chem Industries, Ltd.), 0.2 g of vinylphosphonic acid (Wako Pure Chem Industries, Ltd.) and 1 kg of water were mixed, and sonicated 4 times at a flow rate of 0.5 L/min using an ultrasonic dispersion device (GSD600HAT, Ginsen Co., Ltd.), and then dried at 150°C for 15 hours to obtain water resistant aluminum nitride powder.

The water resistance of the resulting aluminum nitride powder, and the viscosity and thermal conductivity of a composite material manufactured with this aluminum nitride powder are shown in Table 1.

### Example 5

1 kg of aluminum nitride powder (Grade F, the BET specific surface area: 3.4 m²/g, Tokuyama Corporation), 8.0 g of vinylphosphonic acid (Wako Pure Chem Industries, Ltd.) and 1 kg of water were sonicated 4 times at a flow rate of 0.5 L/min using an ultrasonic dispersion device (GSD600HAT, Ginsen Co., Ltd.), and then dried at 150°C for 15 hours to obtain water resistant aluminum nitride powder.

The water resistance of the resulting aluminum nitride powder, and the viscosity and thermal conductivity of a composite material manufactured with this aluminum nitride powder are shown in Table 1.

### Example 6

1 kg of aluminum nitride powder (Grade F, the BET specific surface area: 3.4 m²/g, Tokuyama Corporation), 9.2 g of propylphosphonic acid (Wako Pure Chem Industries, Ltd.) and 1 kg of water were sonicated 2 times at a flow rate of 0.5 L/min using an ultrasonic dispersion device (GSD600HAT, Ginsen Co., Ltd.), and then dried at 200°C for 15 hours to obtain water resistant aluminum nitride powder.

The water resistance of the resulting aluminum nitride powder, and the viscosity and thermal conductivity of a composite material manufactured with this aluminum nitride powder are shown in Table 1.

### Example 7

1 kg of aluminum nitride powder (Grade F, the BET specific surface area: 3.4 m²/g, Tokuyama Corporation), 8.0 g of acid phosphoxy ethyl metacrylate (Phosmer M, Uni-Chemical) and 1 kg of water were sonicated 4 times at a flow rate of 0.5 L/min using an ultrasonic dispersion device (GSD600HAT, Ginsen Co., Ltd.), and then dried at 150°C for 15 hours to obtain water resistant aluminum nitride powder.

The water resistance of the resulting aluminum nitride powder, and the viscosity and thermal conductivity of a composite material manufactured with this aluminum nitride powder are shown in Table 1.

Note that acid phosphoxy ethyl metacrylate is an ester of phosphoric acid and hydroxyethyl methacrylate (a mixture of monoester and diester).

### Example 8

1 kg of aluminum nitride powder (Grade F, the BET specific surface area: 3.4 m²/g, Tokuyama Corporation), 15.0 g of aqueous aluminium phosphate (100 L, 8.5 wt% Al₂O₃ and 33.0 wt% P₂O₅ in the oxide converted concentration, Taki Chemical Co., Ltd.) and 1 kg of water were mixed, and sonicated 3 times at a flow rate of 0.5 L/min using an ultrasonic dispersion device (GSD600HAT, Ginsen Co., Ltd.). The mixture after sonication was dried with a spray dryer (R-100, Preci Co., Ltd.) at an inlet temperature of 200°C, and then further dried at 250°C for 15 hours to obtain water resistant aluminum nitride powder.

The water resistance of the resulting aluminum nitride powder, and the viscosity and thermal conductivity of a composite material manufactured with this aluminum nitride powder are shown in Table 1.

### Example 9

1 kg of aluminum nitride powder (Grade F, the BET specific surface area: 3.4 m²/g, Tokuyama Corporation), 15.0 g of aqueous aluminium phosphate (100 L, 8.5 wt% Al₂O₃ and 33.0 wt% P₂O₅ in the oxide converted concentration, Taki Chemical Co., Ltd.), 0.20 g of vinylphosphonic acid (Wako Pure Chem Industries, Ltd.) and 1 kg of water were mixed, and sonicated 3 times at a flow rate of 0.5 L/min using an ultrasonic dispersion device (GSD600HAT, Ginsen Co., Ltd.). The mixture after sonication was dried with a spray dryer (R-100, Preci Co., Ltd.) at an inlet temperature of 200°C, and then further dried at 250°C for 15 hours to obtain water resistant aluminum nitride powder.

The water resistance of the resulting aluminum nitride powder, and the viscosity and thermal conductivity of a composite material manufactured with this aluminum nitride powder are shown in Table 1.

### Example 10

1 kg of aluminum nitride powder (Grade F, the BET specific surface area: 3.4 m²/g, Tokuyama Corporation), 15.0 g of aqueous aluminium phosphate (100 L, 8.5 wt% Al₂O₃ and 33.0 wt% P₂O₅ in the oxide converted concentration, Taki Chemical Co., Ltd.), 0.20 g of phenylphosphonic acid (Wako Pure Chem Industries, Ltd.) and 1 kg of water were mixed, and sonicated 3 times at a flow rate of 0.5 L/min using an ultrasonic dispersion device (GSD600HAT, Ginsen Co., Ltd.). The mixture after sonication was dried with a spray dryer (R-100, Preci Co., Ltd.) at an inlet temperature of 200°C, and then further dried at 250°C for 15 hours to obtain water resistant aluminum nitride powder.

The water resistance of the resulting aluminum nitride powder, and the viscosity and thermal conductivity of a composite material manufactured with this aluminum nitride powder are shown in Table 1.

### Example 11

Using an attritor (MA-01C, Mitsui Miike Machinery Co., Ltd.), 1 kg of aluminum nitride powder (Grade UM, the BET specific surface area: 1.1 m²/g, Toyo Aluminium K.K.), 5.0 g of phosphoric acid (Special grade, H₃PO₄ content 85 wt%, (Wako Pure Chem Industries, Ltd.) and 1.5 kg of ethanol were dispersed and mixed, and then dried at 120°C for 15 hours to obtain water resistant aluminum nitride powder.

The water resistance of the resulting aluminum nitride powder, and the viscosity and thermal conductivity of a composite material manufactured with this aluminum nitride powder are shown in Table 1.

### Example 12

Using an attritor (MA-01C, Mitsui Miike Machinery Co., Ltd.), 1 kg of aluminum nitride powder (Grade JD, the BET specific surface area: 2.2 m²/g, Toyo Aluminium K.K.), 4.0 g of phosphoric acid (Special grade, H₃PO₄ content 85 wt%, Wako Pure Chem Industries, Ltd.) and 1.5 kg of ethanol were dispersed and mixed, and then dried at 120°C for 15 hours to obtain water resistant aluminum nitride powder.

The water resistance of the resulting aluminum nitride powder, and the viscosity and thermal conductivity of a composite material manufactured with this aluminum nitride powder are shown in Table 1.

### Comparative Example 1

The water resistance of aluminum nitride powder (Grade H, the BET specific surface area: 2.6 m²/g, Tokuyama Corporation), and the viscosity and thermal conductivity of a composite material manufactured with this aluminum nitride powder are shown in Table 2.

### Comparative Example 2

The water resistance of aluminum nitride powder (Grade UM, the BET specific surface area: 1.1 m²/g, Toyo Aluminium K.K.), and the viscosity and thermal conductivity of a composite material manufactured with this aluminum nitride powder are shown in Table 2.

### Comparative Example 3

The water resistance of aluminum nitride powder (Grade JD, the BET specific surface area: 2.2 m²/g, Toyo Aluminium K.K.), and the viscosity and thermal conductivity of a composite material manufactured with this aluminum nitride powder are shown in Table 2.

### Comparative Example 4

Using a kneading mixer (ACM-5LVT, Kodaira Seisakusho Co., Ltd.), 1 kg of aluminum nitride powder (Grade H, the BET specific surface area: 2.6 m²/g, Tokuyama Corporation), 7.1 g of phosphoric acid (Special grade, H₃PO₄ content 85 wt%, Wako Pure Chem Industries, Ltd.) and 600 g of water were dispersied and mixed for 30 minutes, and then dried at 120°C for 15 hours to obtain phosphoric acid-treated aluminum nitride powder.

The water resistance of the resulting aluminum nitride powder, and the viscosity and thermal conductivity of a composite material manufactured with this aluminum nitride powder are shown in Table 2.

### Comparative Example 5

With a mortar, 1 kg of aluminum nitride powder (Grade H, the BET specific surface area: 2.6 m²/g, Tokuyama Corporation), 9.4 g of phosphoric acid (Special grade, H₃PO₄ content 85wt%, Wako Pure Chem Industries, Ltd.), and 1.5 kg of water were mixed, and then dispersed and mixed at a pressure of 150 MPa using a Nanomizer (NMS-200L, Nanomizer Inc). Subsequently, this dispersion mixture was dried at 200°C, and then further dried in a 120°C oven for 15 hours to obtain phosphoric acid-treated aluminum nitride powder.

The water resistance of the resulting aluminum nitride powder, and the viscosity and thermal conductivity of a composite material manufactured with this aluminum nitride powder are shown in Table 2.

### Comparative Example 6

Using a kneading mixer (ACM-5LVT, Kodaira Seisakusho Co., Ltd.), 1 kg of aluminum nitride powder (Grade JD, the BET specific surface area: 2.2 m²/g, Toyo Aluminium K.K.), 6.0 g of phosphoric acid (Wako Pure Chem Industries, Ltd.) and 1.5 kg of water were dispersied and mixed for 30 minutes, and then dried at 120°C for 15 hours to obtain phosphoric acid-treated aluminum nitride powder.

The water resistance of the resulting aluminum nitride powder, and the viscosity and thermal conductivity of a composite material manufactured with this aluminum nitride powder are shown in Table 2.

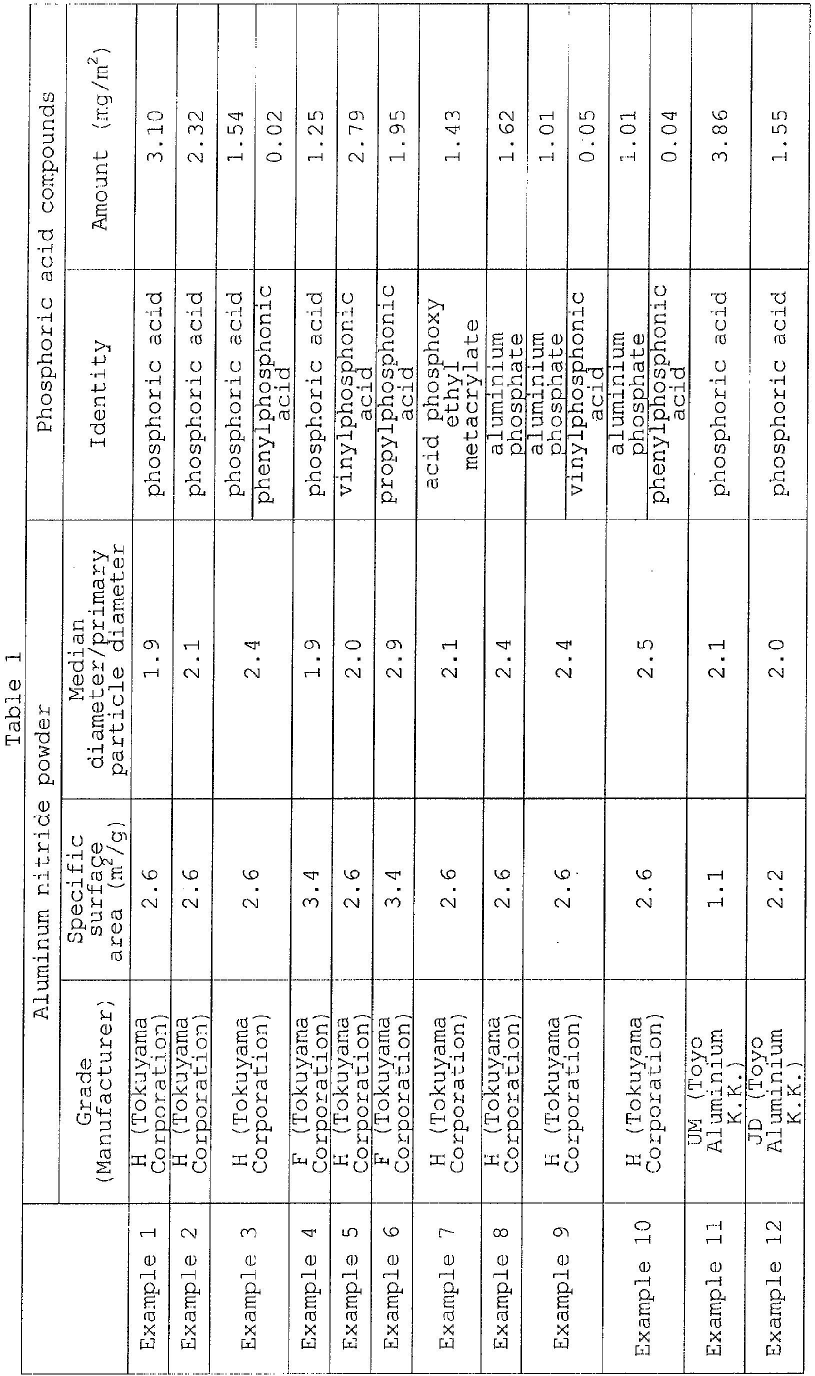

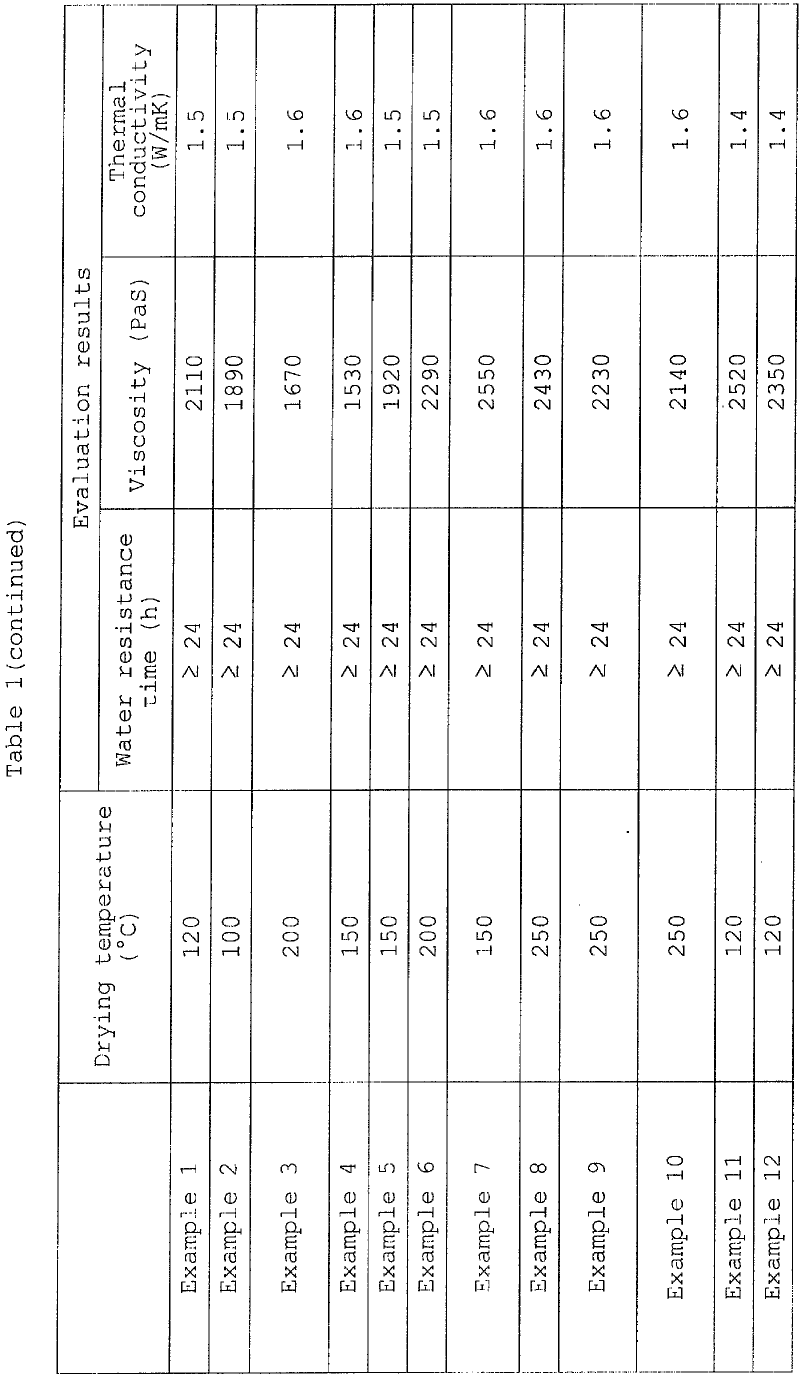

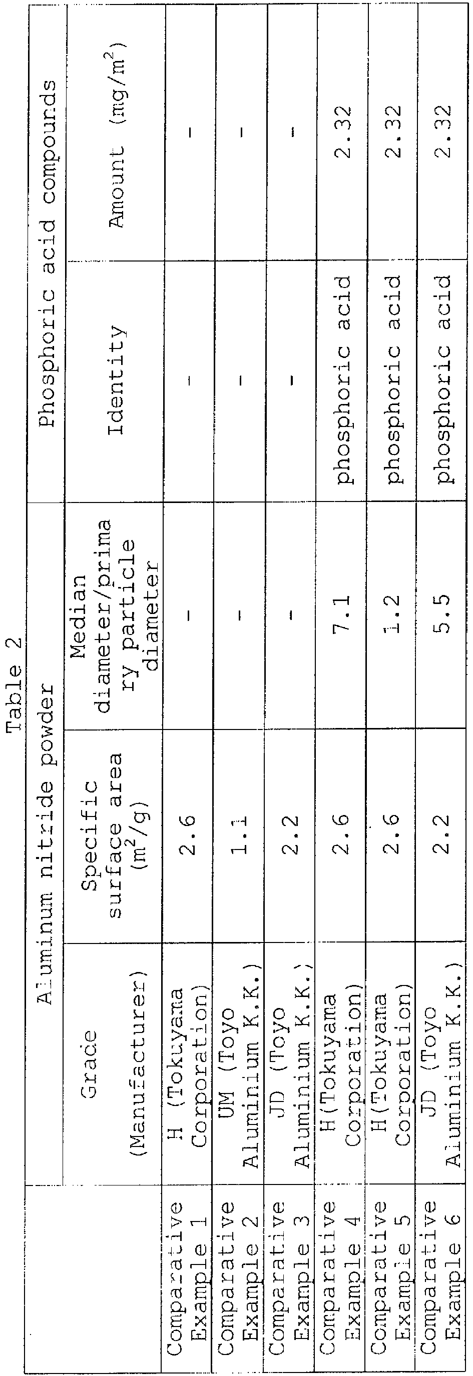

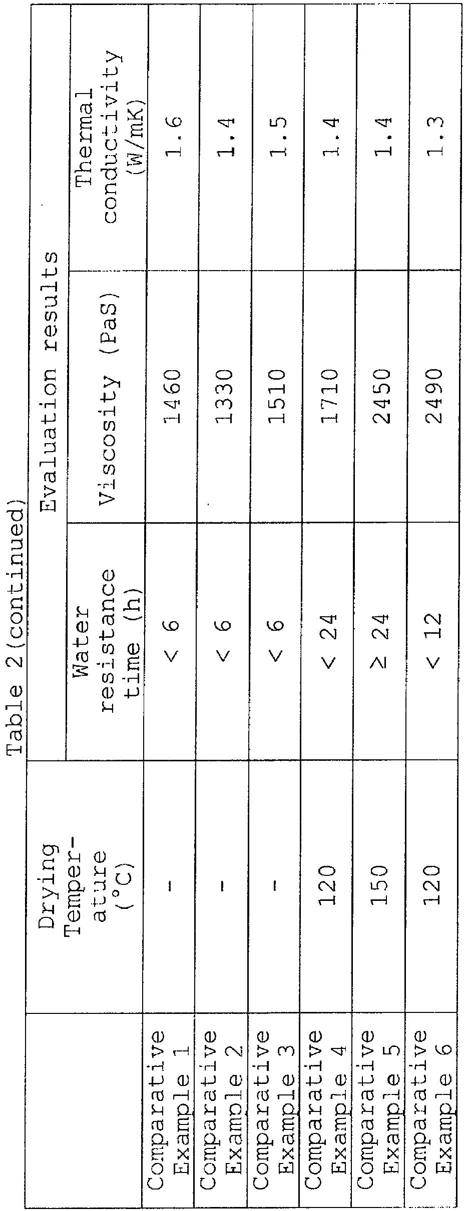

### Example 13

With a mortar, 20 g of aluminum nitride powder (Grade H, the BET specific surface area: 2.6 m²/g. Tokuyama Corporation), 0.14 g of phosphoric acid (Special grade, H₃PO₄ content 85 wt%, Wako Pure Chem Industries, Ltd.), 8.0 mg of phenylphosphonic acid (Wako Pure Chem Industries, Ltd.) and 20 g of water were mixed, and then dried at 120°C for 15 hours.

The thickness of the aluminum oxide layer of the raw powder, and the water resistance of the resulting aluminum nitride powder, and the viscosity and thermal conductivity of a composite material manufactured with this aluminum nitride powder are shown in Table 3.

### Example 14

With a mortar, 20 g of aluminum nitride powder (Grade H, the BET specific surface area: 2.6 m²/g, Tokuyama Corporation), 0.160 g of phosphoric acid (Special grade, H₃PO₄ content 85 wt%, Wako Pure Chem Industries, Ltd.), 4.0 mg of phenylphosphonic acid (Wako Pure Chem Industries, Ltd.) and 20 g of ethanol were mixed, and then dried at 120°C for 15 hours to obtain water resistant aluminum nitride powder.

The thickness of the aluminum oxide layer of the raw powder, and the water resistance of the resulting aluminum nitride powder, and the viscosity and thermal conductivity of a composite material manufactured with this aluminum nitride powder are shown in Table 3.

### Example 15

To a sample vial, 20 g of aluminum nitride powder (Grade H, the BET specific surface area: 2.6 m²/g, Tokuyama Corporation), 0.08 g of phosphoric acid (Special grade, H₃PO₄ content 85 wt%, Wako Pure Chem Industries, Ltd.), 4.0 mg of phenylphosphonic acid (Wako Pure Chem Industries, Ltd.) and 20 g of isopropanol were introduced, and shaken for 1 minute, and then ultrasonic irradiation was performed in an ultrasonic cleaning bath for 15 minutes to obtain a slurry. The ratio of median diameter/primary particle diameter of the resulting slurry was 2.2. Subsequently, the slurry was heated at 100°C for 15 hours to obtain water resistant aluminum nitride powder by removing isopropanol.

The thickness of the aluminum oxide layer of the raw powder, and the water resistance of the resulting aluminum nitride powder, and the viscosity and thermal conductivity of a composite material manufactured with this aluminum nitride powder are shown in Table 3.

### Example 16

Aluminum nitride powder (Grade UM, the BET specific surface area: 1.1 m²/g, Toyo Aluminium K.K.) was heated at 800°C for 1 hour under the atmospheric pressure to perform surface oxidation treatment. The BET specific surface area of the resulting aluminum nitride powder was 1.3 m²/g, and the thickness of the aluminum oxide layer was 5.5 nm.

To a sample vial, 20 g of the aluminum nitride powder after the surface oxidation treatment, 0.060 g of phosphoric acid (Special grade, H₃PO₄ content 85 wt%, Wako Pure Chem Industries, Ltd.), 9.0 mg of phenylphosphonic acid (Wako Pure Chem Industries, Ltd.) and 20 g of dioxane were introduced, and shaken for 1 minute, and then ultrasonic irradiation was performed in an ultrasonic cleaning bath for 15 minutes to obtain a slurry. The ratio of median diameter/primary particle diameter of the resulting slurry was 2.5. Subsequently, the slurry was heated at 200°C for 15 hours to obtain water resistant aluminum nitride powder by removing dioxane.

The thickness of the aluminum oxide layer of the raw powder, and the water resistance of the resulting aluminum nitride powder, and the viscosity and thermal conductivity of a composite material manufactured with this aluminum nitride powder are shown in Table 3.

### Example 17

To a sample vial, 20 g of the aluminum nitride powder subjected to the surface oxidation treatment in Example 16, 0.035 g of phosphoric acid (Special grade, H₃PO₄ content 85 wt%, Wako Pure Chem Industries, Ltd.), 0.7 mg of phenylphosphonic acid (Wako Pure Chem Industries, Ltd.) and 20 g of water were introduced, and shaken for 1 minute, and then ultrasonic irradiation was performed in an ultrasonic cleaning bath for 15 minutes to obtain a slurry. The ratio of median diameter/primary particle diameter of the resulting slurry was 2.2. Subsequently, the slurry was dried at 200°C for 15 hours to obtain water resistant aluminum nitride powder.

The thickness of the aluminum oxide layer of the raw powder, and the water resistance of the resulting aluminum nitride powder, and the viscosity and thermal conductivity of a composite material manufactured with this aluminum nitride powder are shown in Table 3.

### Example 18

To a sample vial, 20 g of the aluminum nitride powder subjected to the surface oxidation treatment in Example 16, 0.035 g of phosphoric acid (Special grade, H₃PO₄ content 85 wt%, Wako Pure Chem Industries, Ltd.), 0.7 mg of phenylphosphonic acid (Wako Pure Chem Industries, Ltd.) and 20 g of water were introduced, and shaken for 1 minute, and then ultrasonic irradiation was performed in an ultrasonic cleaning bath for 15 minutes to obtain a slurry. The ratio of median diameter/primary particle diameter of the resulting slurry was 2.2. Subsequently, the slurry was dried at 200°C for 15 hours to obtain water resistant aluminum nitride powder.

The thickness of the aluminum oxide layer of the raw powder, and the water resistance of the resulting aluminium nitride powder, and the viscosity and thermal conductivity of a composite material manufactured with this aluminum nitride powder are shown in Table 3.

### Example 19

Aluminum nitride powder (Grade JD, the BET specific surface area: 2.2 m²/g, Toyo Aluminium K.K.) was heated at 800°C for 1 hour under the atmospheric pressure to perform surface oxidation treatment. The BET specific surface area of the resulting aluminum nitride powder was 2.3 m²/g, and the thickness of the aluminum oxide layer was 6.1 nm.

Sequentially, 20 g of the aluminum nitride powder after the surface oxidation treatment, 0.080 g of phosphoric acid (Special grade, H₃PO₄ content 85 wt%, Wako Pure Chem Industries, Ltd.), 1.0 mg of phenylphosphonic acid (Wako Pure Chem Industries, Ltd.) and 20 g of isopropanol were introduced into a sample vial, and shaken for 1 minute, and then ultrasonic irradiation was performed in an ultrasonic cleaning bath for 15 minutes to obtain a slurry. The ratio of median diameter/primary particle diameter of the resulting slurry was 2.3. Subsequently, the slurry was dried at 200°C for 15 hours to obtain water resistant aluminum nitride powder.

The thickness of the aluminum oxide layer of the raw powder, and the water resistance of the resulting aluminum nitride powder, and the viscosity and thermal conductivity of a composite material manufactured with this aluminum nitride powder are shown in Table 3.

### Example 20

To a sample vial, 20 g of aluminum nitride powder (Grade F, the BET specific surface area: 3.4 m²/g, Tokuyama Corporation), 0.20 g of phosphoric acid (Special grade, H₃PO₄ content 85 wt%, Wako Pure Chem Industries, Ltd.), 9.0 mg of phenylphosphonic acid (Wako Pure Chem Industries, Ltd.) and 20 g of dioxane were introduced, and shaken for 1 minute, and then ultrasonic irradiation was performed in an ultrasonic cleaning bath for 15 minutes to obtain a slurry. The ratio of median diameter/primary particle diameter of the resulting slurry was 2.4. Subsequently, the slurry was dried at 180°C for 15 hours to obtain water resistant aluminum nitride powder.

The thickness of the aluminum oxide layer of the raw powder, and the water resistance of the resulting aluminum nitride powder, and the viscosity and thermal conductivity of a composite material manufactured with this aluminum nitride powder are shown in Table 3.

### Example 21

Aluminum nitride powder (Grade H, the BET specific surface area: 2.6 m²/g, Tokuyama Corporation) was heated at 900°C for 1 hour under the atmospheric pressure to perform surface oxidation treatment. The BET specific surface area of the resulting aluminum nitride powder was 2.8 m²/g, and the thickness of the aluminum oxide layer was 6.6 nm.

Sequentially, 20 g of the aluminum nitride powder after the surface oxidation treatment, 0.10 g of phosphoric acid (Special grade, H₃PO₄ content 85 wt%, (Wako Pure Chem Industries, Ltd.), 15.0 mg of phenylphosphonic acid (Wako Pure Chem Industries, Ltd.) and 20 g of dioxane were introduced into a sample vial, and shaken for 1 minute, and then ultrasonic irradiation was performed in an ultrasonic cleaning bath for 15 minutes to obtain a slurry. The ratio of median diameter/primary particle diameter of the resulting slurry was 2.4. Subsequently, the slurry was dried at 180°C for 15 hours to obtain water resistant aluminum nitride powder.

The thickness of the aluminum oxide layer of the raw powder, and the water resistance of the resulting aluminum nitride powder, and the viscosity and thermal conductivity of a composite material manufactured with this aluminum nitride powder are shown in Table 3.

### Example 22

Mixed were 1 kg of aluminum nitride powder (Grade H, the BET specific surface area: 2.6 m²/g, Tokuyama Corporation), 15.0 g of aqueous aluminium phosphate (100L, 8.5 wt% Al₂O₃ and 33.0 wt% P₂O₅ in the oxide converted concentration, Taki Chemical Co., Ltd.), 0.20 g of phenylphosphonic acid and 1 kg of water. This mixture was sonicated 3 times at a flow rate of 0.5 L/min using an ultrasonic dispersion device (GSD600HAT, Ginsen Co., Ltd.) to obtain a slurry. The ratio of median diameter/primary particle diameter of the resulting slurry was 2.2.

Subsequently, the slurry obtained above was dried with a spray dryer (R-100, Preci Co., Ltd.) at an inlet temperature of 200°C, and then further dried at 250°C for 15 hours to obtain water resistant aluminum nitride powder.

The thickness of the aluminum oxide layer of the raw powder, and the water resistance of the resulting aluminum nitride powder, and the viscosity and thermal conductivity of a composite material manufactured with this aluminum nitride powder are shown in Table 3.

### Example 23

1 kg of aluminum nitride powder (Grade H, the BET specific surface area: 2.6 m²/g, Tokuyama Corporation), 20.0 g of aqueous aluminium phosphate (100 L, 8.5 wt% Al₂O₃ and 33.0 wt% P₂O₅ in the oxide converted concentration, Taki Chemical Co., Ltd.), 0.20 g of phenylphosphonic acid and 1 kg of water were mixed, and sonicated 3 times at a flow rate of 0.5 L/min using an ultrasonic dispersion device (GSD600HAT, Ginsen Co., Ltd.) to obtain a slurry. The ratio of median diameter/primary particle diameter of the resulting slurry was 2.3.

Subsequently, the slurry obtained above was dried with a spray dryer (R-100, Preci Co.,Ltd.) at an inlet temperature of 200°C, and then further dried at 250°C for 15 hours to obtain water resistant aluminum nitride powder.

The thickness of the aluminum oxide layer of the raw powder, and the water resistance of the resulting aluminum nitride powder, and the viscosity and thermal conductivity of a composite material manufactured with this aluminum nitride powder are shown in Table 3.

### Example 24

With a mortar, 20 g of aluminum nitride powder (Grade H, the BET specific surface area: 2.6 m²/g, Tokuyama Corporation), 0.15 g of phosphoric acid (Special grade, H₃PO₄ content 85 wt%, Wako Pure Chem Industries, Ltd.) and 20 g of water were mixed, and then dried at 120°C for 15 hours to obtain phosphoric acid-treated aluminum nitride powder.

The thickness of the aluminum oxide layer of The raw powder, and the water resistance of the resulting aluminum nitride powder, and the viscosity and thermal conductivity of a composite material manufactured with this aluminum nitride powder are shown in Table 3.

### Example 25

With a mortar, 20 g of aluminum nitride powder (Grade H, the BET specific surface area: 2.6 m²/g, Tokuyama Corporation), 0.14 g of phosphoric acid (Special grade, H₃PO₄ content 85 wt%, Wako Pure Chem Industries, Ltd.), 4mg of laurylphosphoric acid (ML-200, Toho Chemical Industry Co., Ltd.) and 20 g of water were mixed, and then dried at 120°C for 15 hours to obtain laurylphosphoric acid-treated aluminum nitride powder.

The thickness of the aluminum oxide layer of the raw powder, and the water resistance of the resulting aluminum nitride powder, and the viscosity and thermal conductivity of a composite material manufactured with this aluminium nitride powder are shown in Table 3.

### Comparative Example 7

To a sample vial, 20 g of aluminum nitride powder (Grade H, the BET specific surface area: 2.6 m²/g, Tokuyama Corporation), 10 mg of phenylphosphonic acid (Wako Pure Chem Industries, Ltd.) and 20 g of water were introduced, and shaken for 1 minute, and ultrasonic irradiation was performed in an ultrasonic cleaning bath for 15 minutes, and then dried at 200°C for 15 hours to obtain phenylphosphonic acid-treated aluminum nitride powder.

The thickness of the aluminum oxide layer of the raw powder, and the water resistance of the resulting aluminum nitride powder, and the viscosity and thermal conductivity of a composite material manufactured with this aluminum nitride powder are shown in Table 4.

### Comparative Example 8

With a mortar, 20 g of aluminum nitride powder (Grade H, the BET specific surface area: 2.6 m²/g, Tokuyama Corporation), 0.78 g of phosphoric acid (Special grade, H₃PO₄ content 85 wt%, Wako Pure Chem Industries, Ltd.), 4 mg of phenylphosphonic acid (Wako Pure Chem Industries, Ltd.) and 20 g of water were mixed, and then dried at 120°C for 15 hours to obtain phenylphosphonic acid-treated aluminum nitride powder.

The thickness of the aluminum oxide layer of the raw powder, and the water resistance of the resulting aluminum nitride powder, and the viscosity and thermal conductivity of a composite material manufactured with this aluminum nitride powder are shown in Table 4.

### Comparative Example 9

With a mortar, 20 g of aluminum nitride powder (Grade H, the BET specific surface area: 2.6 m²/g, Tokuyama Corporation), 0.02 g of phosphoric acid (Special grade, purity 85 wt%, Wako Pure Chem Industries, Ltd.), 4 mg of phenylphosphonic acid (Wako Pure Chem Industries, Ltd.) and 20 g of water were mixed, and then dried at 120°C for 15 hours to obtain phenylphosphonic acid-treated aluminum nitride powder.

The thickness of the aluminum oxide layer of the raw powder, and the water resistance of the resulting aluminum nitride powder, and the viscosity and thermal conductivity of a composite material manufactured with this aluminum nitride powder are shown in Table 4.

The results from Comparative Examples 1 to 3 are also shown in Table 4.

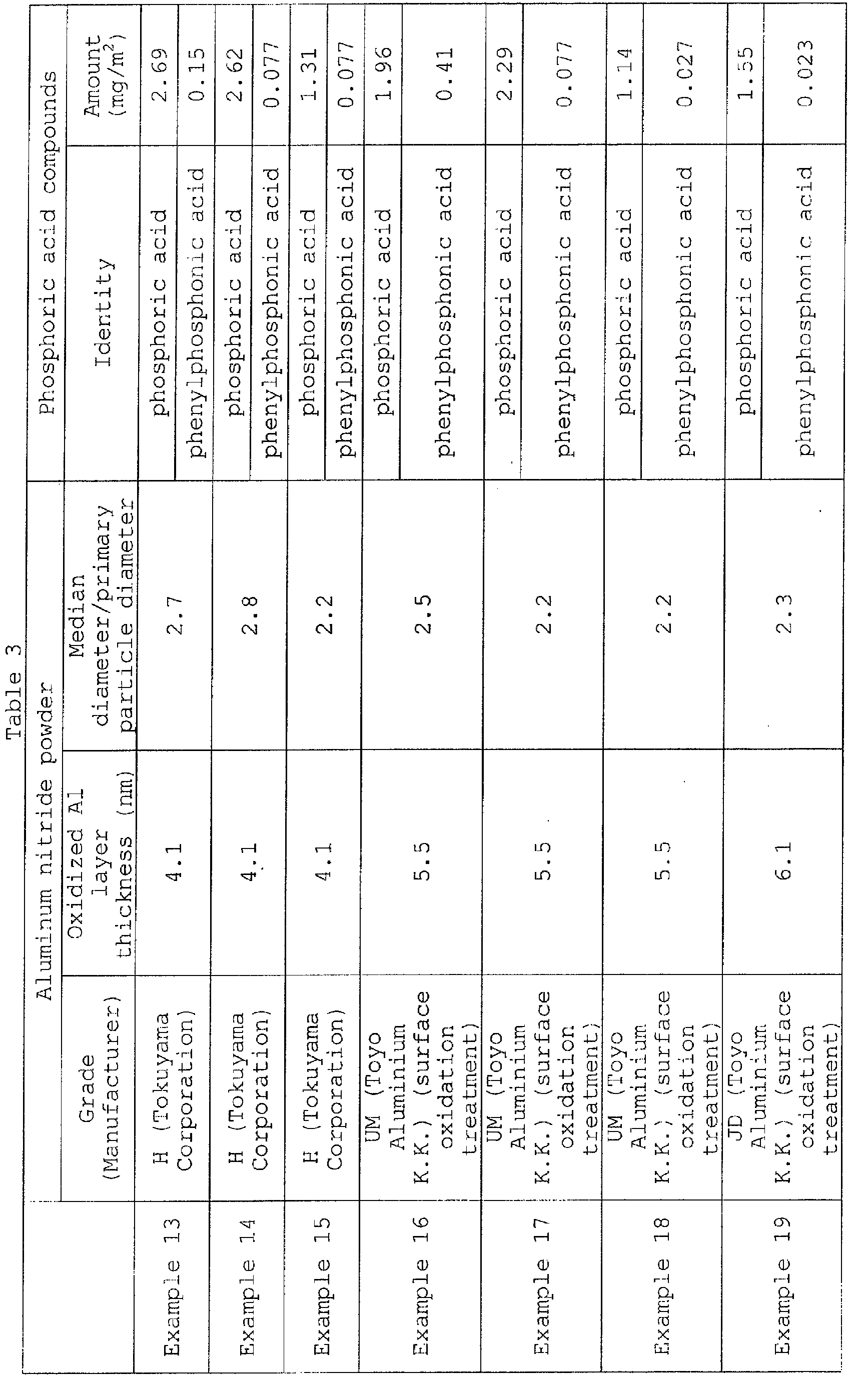

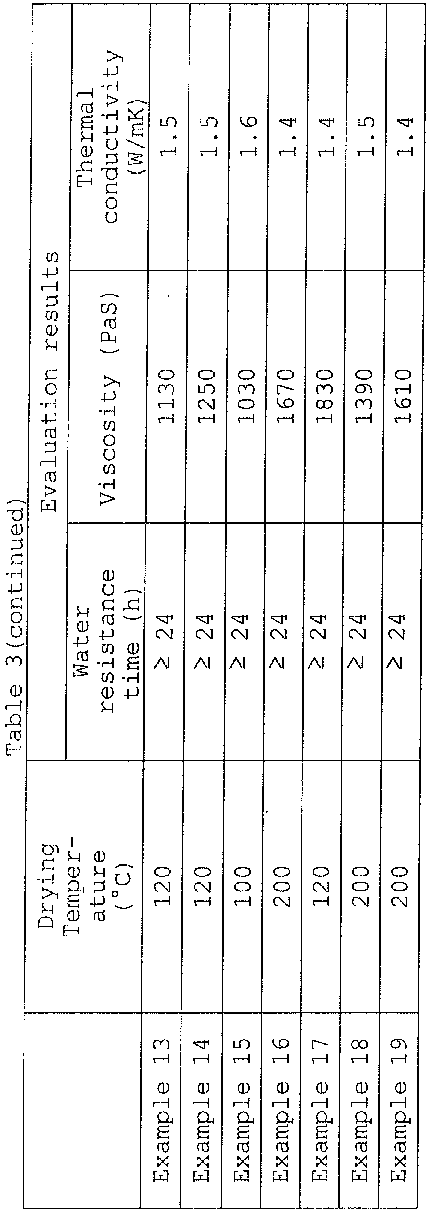

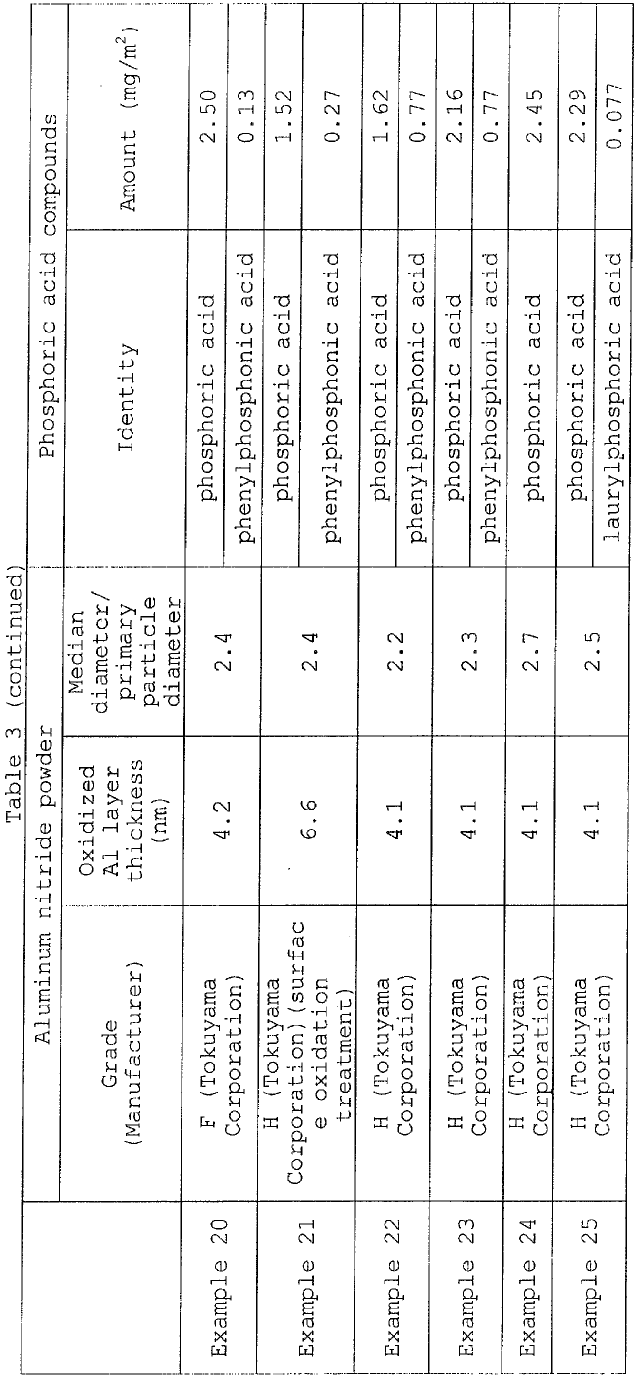

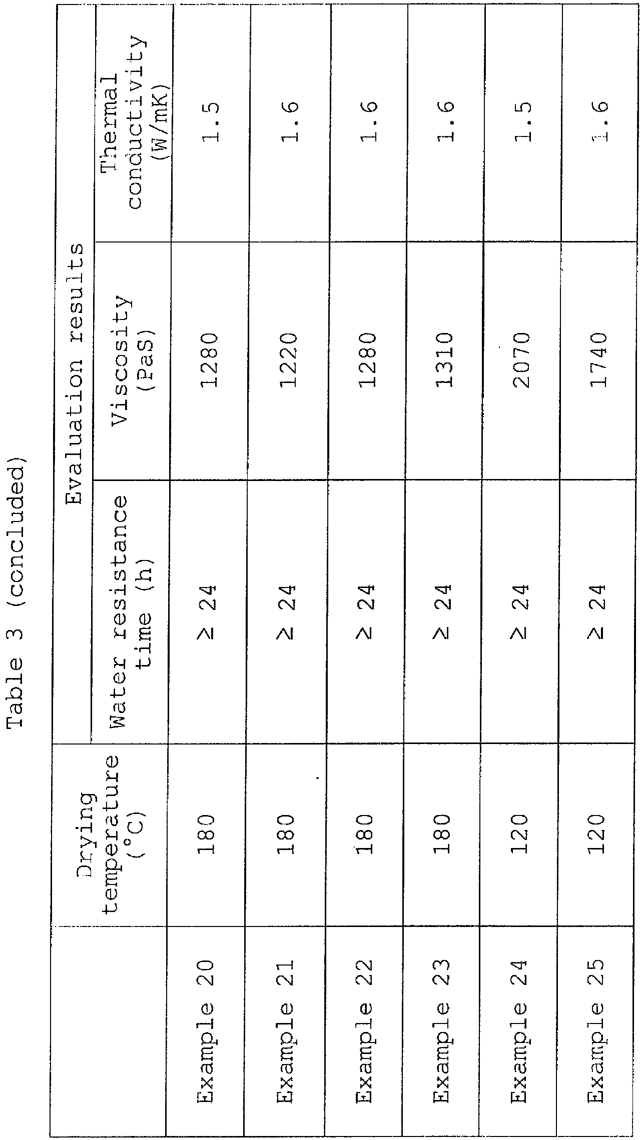

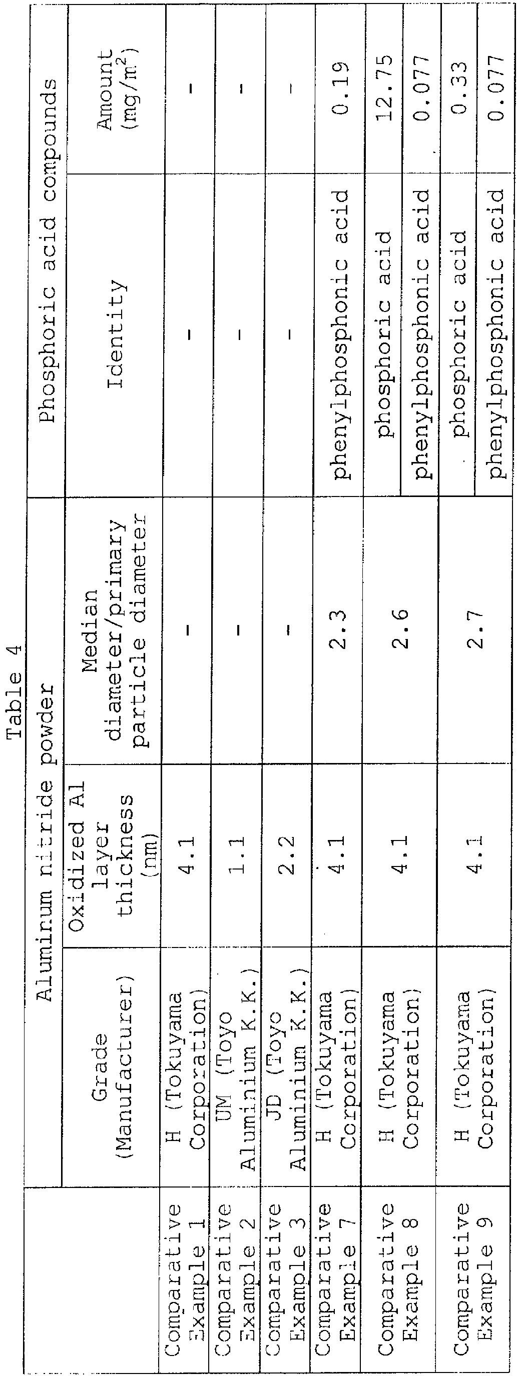

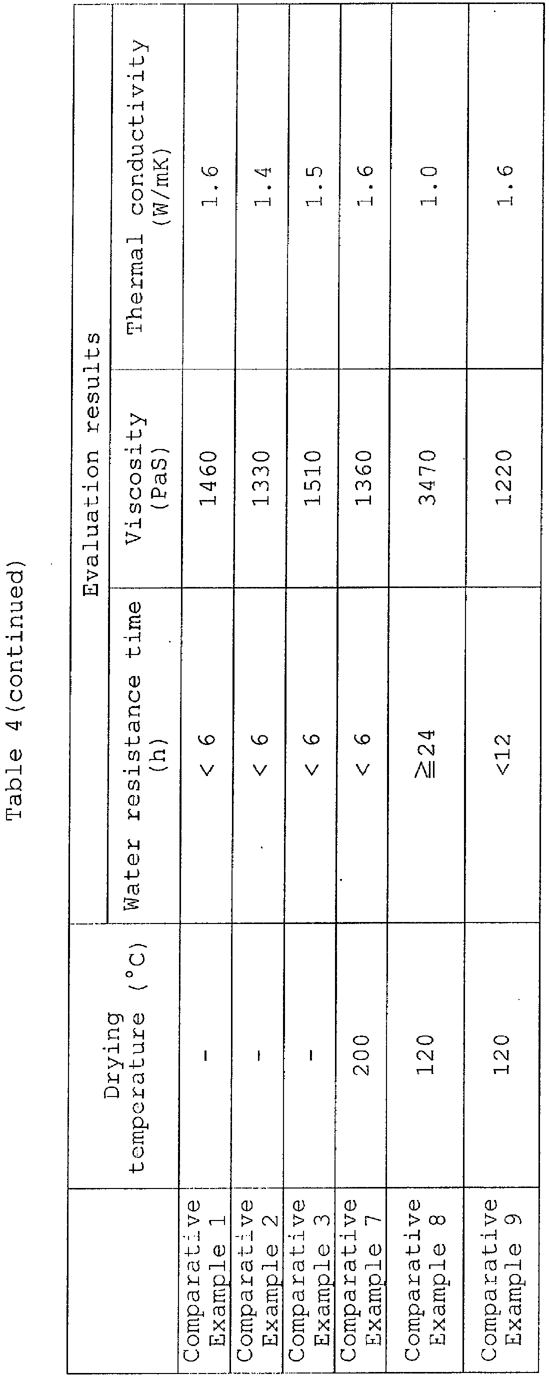

### Example 26 (Analysis example)

A content ratio was quantified for each of phosphoric acid and phenylphosphonic acid in the water resistant aluminum nitride powder manufactured in Example 16 described above by the corresponding methods as described below. The results showed that the calculated values are 1.87 mg/m² and 0.38 mg/m² for phosphoric acid and phenylphosphonic acid, respectively, each of which showed a good agreement with the initial amount.

The above values are both orthophosphoric acid ion-converted values.

### <Quantitative analysis of phosphoric acid>

To a Teflon^{®} pressure tight vessel, 0.25 g of water resistant aluminum nitride powder and 10 mL of aqueous potassium hydroxide (the concentration of 1 (w/v)%) were introduced, and maintained at 160°C for 16 hours, and then cooled down to room temperature. The entire liquid in the pressure tight vessel was transferred to a volumetric flask and diluted with ultrapure water to 100 mL, and then the content of phosphorus was quantified using an ICP emission spectrophotometer (Shimadzu Corporation, Model "ICPS-7510") and converted into the amount of orthophosphoric acid ions per unit area of the water resistant aluminum nitride powder.

### <Quantitative analysis of phenylphosphonic acid>

1 g of water resistant aluminum nitride powder, 2 mL of tetrahydrofuran, 0.5 mL of a sililation reagent (a commercial product; a mixture of hexamethyldisilane, trimethylchlorosilane and pyridine: GL Sciences, Inc.) and 1 µL of methyl palmitate (Tokyo Kagaku Kogyo K.K.) as an internal standard were transferred into a test tube, and sealed. This was well strirred and left to stand for 1 hour at 60°C, and then the supernatant was recovered by centrifugation. The content of the phenylphosphonic acid trimethylsilyl compound in the supernatant was quantified by gas chromatography analysis, and converted into the amount of orthophosphoric acid ions per unit area of the water resistant aluminum nitride powder.

### ADVANTAGEOUS EFFECTS OF INVENTION

The water resistant aluminum nitride powder manufactured according to the method of the present invention shows good water resistance with a least thickness of a treatment agent layer which confers such water resistance, and less increased viscosity when applied to a thermal conductive composite material.

Therefore, the thermal conductive composite material manufactured by applying the water resistant aluminum nitride powder manufactured according to the method of the present invention has exceptionally superior thermal conductivity.

## Claims

1. A method of manufacturing water resistant aluminium nitride powder, the method comprising: in a solvent,
performing phosphoric acid compound treatment in which at least one phosphoric acid compound selected from the group consisting of phosphoric acid, metal salts of phosphoric acid and organic phosphoric acid having an organic group with 12 or less carbon atoms is contacted with aluminum nitride powder dispersed in the solvent so that the ratio of median diameter/primary particle diameter is 1.4 to 5,
thereby the phosphoric acid compound is present on the surface of the aluminum nitride powder in an amount of 0.5 to 10 mg/m² in an orthophosphoric acid ion equivalence.

2. The method of manufacturing water resistant aluminium nitride powder according to claim 1, wherein the phosphoric acid compound treatment step comprises:
contacting a first phosphoric acid compound comprising at least one selected from the group consisting of phosphoric acid and metal salts of phosphoric acid, and
a second phosphoric acid compound comprising at least one selected from organic phosphoric acid having an organic group with 12 or less carbon atoms with the aluminium nitride powder simultaneously or sequentially in no particular order.

3. The method of manufacturing water resistant aluminum nitride powder according to claim 1 or 2, wherein the organic phosphoric acid having an organic group with 12 or less carbon atoms comprises phenylphosphonic acid.

4. The method of manufacturing water resistant aluminum nitride powder according to claim 3, wherein the amount of the phenylphosphonic acid on the surface of the aluminum nitride powder is 0.002 to 1.5 mg/m² in the orthophosphoric acid ion equivalence.

5. The water resistant aluminum nitride powder manufactured by the method of manufacturing water resistant aluminum nitride powder according to claim 1 or 2.
